# EUROPÄISCHE PATENTSCHRIFT

(11) **EP 0 783 137 B1**
(45) Veröffentlichungstag und Bekanntmachung des Hinweises auf die Patenterteilung: **23.01.2008**
(21) Anmeldenummer: 96118016.3
(22) Anmeldetag: 09.11.1996
(51) Int. Cl.: G03F 7/20

(54) **REMA-Objektiv für Mikrolithographie-Projektionsbelichtungsanlagen**
REMA objective for microlithographic projection illumination
Objectif REMA pour dispositifs d'illumination de microlithographie par projection

(30) Priorität: 27.12.1995 DE 19548805
(43) Veröffentlichungstag der Anmeldung: 09.07.1997
(73) Patentinhaber: Carl Zeiss SMT AG, 73447 Oberkochen (DE)
(72) Erfinder: Fürter, Gerd, 73479 Ellwangen (DE); Wangler, Johannes, 89551 Königsbronn (DE); Dinger, Udo, 73447 Oberkochen (DE); Ittner, Gerhard, 73447 Oberkochen (DE)
(74) Vertreter: Schultz, Jörg Martin

(56) Entgegenhaltungen:
- EP-A- 0 269 926
- EP-A- 0 526 242
- EP-A- 0 687 956
- WO-A-84/01039
- DE-A- 4 417 489
- E. HECHT : "Optics" 1987 , ADDISON-WESLEY XP002113677 * Kapitel 6.3 ii) 'Coma' *

## Beschreibung

Die Erfindung betrifft ein REMA-Objektiv. Dies ist ein Objektiv, mit dem eine Retikel-Maskiereinrichtung (REMA) in die Ebene des Retikels, das die strukturierte Maske für die Lithographie trägt, abgebildet wird. Der auf dem Retikel ausgeleuchtete Bereich wird damit scharf berandet. Gewöhnlich ist die Retikel-Maskiereinrichtung mit verstellbaren Schneiden aufgebaut. Die Abbildung ist normalerweise vergrößernd.

Ein REMA-Objektiv gelangt in Mikrolithographie-Projektionsbelichtungsanlagen (Stepper) zum Einsatz.

Aus DE-U 94 09 744 ist eine Beleuchtungseinrichtung für eine mikrolithographische Projektionsbelichtungsanlage bekannt, bei der in angegebener Reihenfolge vorgesehen sind: Lichtquelle, Verschluß, Einkoppelobjektiv (Zoom-Axicon), Glasstab als Integrator, Retikel-Masking-System, REMA-Objektiv zur Abbildung der im Retikel-Masking-System liegenden Zwischenfeldebene auf das Retikel, enthaltend eine erste Linsengruppe, eine Pupillen-Zwischenebene, eine zweite Linsengruppe, einen Umlenkspiegel, eine dritte Linsengruppe und die Retikel-Ebene mit dem Retikel. Danach folgt ein Projektionsobjektiv, das normalerweise verkleinert und - zum Beispiel bei nicht telezentrischem Eingang - eine innenliegende Pupillenebene enthält, dann der Wafer in der Bildebene.

In dem System nach EP 0 526 242 A1 ist nach dem Integrator, hier ein Wabenkondensor, zunächst ein Projektionsobjektiv vorgesehen, bevor das Retikel-Masking-System folgt. Über zwei Linsengruppen und Spiegel ist das Retikel-Masking-System zur Retikel-Ebene optisch konjugiert, wird also abgebildet. Zugleich wird die Blende am Austritt des Integrators - die sekundäre Lichtquelle - durch die zwei Linsengruppen und Teile des Projektionsobjektivs auf die Pupille des Projektionsobjektivs abgebildet. Zu Bildfehlern wird dabei nichts ausgesagt.

In der PCT/EP95/01719 der Anmelderin ist ein höchstaperturiges katadioptrisches Reduktionsobjektiv für die Mikrolithographie beschrieben, zu dessen Ausführungsbeispiel nach Figur 3 und Tabelle 2 das hier gezeigte Ausführungsbeispiel eines REMA-Objektivs genau passend ist. Die PCT-Anmeldung ist daher, wie auch die DE-U ausdrücklich Teil der Offenbarung dieser Patentanmeldung. Tabelle 2 gibt die Tabelle 2 der PCT-Anmeldung nochmals wieder.

Aufgabe der Erfindung ist es, ein besonders hochwertiges REMA-Objektiv anzugeben.

Dabei soll die Lage der Hauptstrahlen auf die Eintrittspupille des Projektionsobjektivs abgestimmt sein bzw. für typische Projektionsobjektive passen. Die in der Objektebene des REMA-Objektivs liegenden Blenden-Kanten müssen einwandfrei auf die Retikel-Ebene abgebildet werden und es wird ein freiliegendes korrigiertes Pupillen-Zwischenbild angestrebt, da dann an dessen Ort weitere Blenden und ähnliches, zum Beispiel zur Maskierung von Teilen des Alignmentsystems, angeordnet werden können.

Gelöst wird diese Aufgabe durch ein REMA-Objektiv nach einem der nebengeordneten Ansprüche 1, 3 oder 6 und die Gesamtanordnung nach Anspruch 11.

Zur Erreichung aller dieser Ziele ist die Einführung großer Winkel in den Strahlengang erfindungsgemäß vorgesehen.

Gemäß Anspruch 1 ist dabei vorgesehen, daß in der retikelseitigen Objektivhälfte eine Linsengruppe liegt, in der die Hauptstrahlhöhen betragsmäßig größer sind als die Randstrahlhöhen, und in der eine zerstreuende, also konkave Fläche mit einem größten Betrag des Sinus des Auftreffwinkels eines Hauptstrahles in Luft (|sin(i_{Haupt})|) größer als 0,35, insbesondere größer als 0,5 ist.

Damit läßt sich primär die Lage der Hauptstrahlen auf die Eintrittspupille des Projektionsobjektivs abstimmen.

Anspruch 2 baut das vorteilhaft aus, indem in Lichtrichtung hinter dem REMA-Objektiv der reziproke Wert der auf das Retikel bezogenen Hauptstrahlschnittweite für achsferne Hauptstrahlen im mathematischen Sinne kleiner ist als für achsnahe Hauptstrahlen.

Anspruch 3 sieht vor, daß vor oder aber vor und nach dem Schnittpunkt der Hauptstrahlen mit der optischen Achse - dieser liegt in der Blendenebene - mindestens eine - vorzugsweise eine der nächstgelegenen vier - optischen Flächen eine zu diesem Schnittpunkt hin gekrümmte Fläche ist, mit einem größten Betrag des Sinus des Auftreffwinkels eines Randstrahls in Luft (|sin(i_{Rand})|) größer als das 0,8-fache der objektseitigen numerischen Apertur.

Nach Anspruch 4 ist vorgesehen, daß zwischen Blendenebene und Retikel (Bildebene des REMA-Objektivs) mindestens eine Linsenfläche liegt, an der der größte Betrag des Sinus des Auftreffwinkels eines Komastrahls in Luft gegen die Flächennormale |sin(i_{Koma max.})| größer als 0,8 mal die eingangsseitige numerische Apertur NAO ist.

Nach Anspruch 5 ist dabei zusätzlich vorgesehen, daß die Abbildung von der Objektebene mit dem Retikelmaskierungssystem auf die Retikelebene so gut ist, daß im Bild einer Hell-Dunkel-Kante die Helligkeitswerte 5% und 95% um weniger als 2%, vorzugsweise 0,5%, des Bildfelddurchmessers auseinanderliegen.

Diese Maßnahmen sind also dazu geeignet, Objektkanten, insbesondere die Schneiden der Retikel-Maskierung, sehr exakt abzubilden.

Anspruch 6 sieht vor, daß zwischen Objektebene und Blendenebene, welche den Schnittpunkt der Hauptstrahlen mit der optischen Achse enthält, ein zur Objektebene hin gekrümmter zerstreuender Luftspalt angeordnet ist. Damit wird die gute Korrektur des Zwischenbildes sichergestellt.

Anspruch 7 sieht dazu die Ausbildung eines Teilobjektivs zur Darstellung einer korrigierten Pupillenebene in der Blendenebene des REMA-Objektivs vor.

Mit den kennzeichnenden Merkmalen des Anspruches 8 ergibt sich eine besonders gute Komakorrektion dieses Teilobjektivs. Dazu ist mindestens eine zur Objektebene hin gekrümmte Hohlfläche vorgesehen, an der der Betrag des Sinus des Auftreffwinkels eines Randstrahls in Luft (|sin(i_{Rand})|) kleiner als 0,8 mal die objektseitige numerische Apertur des REMA-Objektivs ist, und der größte Betrag des Sinus des Auftreffwinkels eines Komastrahls (|sin(i_{Koma-max.})|) größer als 0,8 mal die objektseitige numerische Apertur des REMA-Objektivs ist.

Die Verwendung eines REMA-Objektivs nach einem oder mehreren der obigen Ansprüche erfolgt vorzugsweise in einer Mikrolithographie-Projektionsbelichtungsanlage, in der die Retikel-Maske am Ausgang eines Glasstabs angeordnet ist, gemäß Anspruch 9. Hier wird der Objektivteil bis zur Blendenebene benötigt. Bei Systemen mit Wabenkondensor ohne Retikel-Maskierungssystem wird nur der nachfolgende Teil, dessen hinterer Teil eine Feldlinse darstellt, benötigt. Besonderer Vorteil der erfindungsgemäßen Lösung ist es, daß am Ende des Glasstabs die Retikel-Maskierung, meist eine verstellbare Blende bestehend aus präzisen Schneiden, angeordnet werden kann, und daß diese sehr präzise auf die Retikel-Ebene abgebildet wird.

Nach Anspruch 10 ist die Verwendung mit einem katadioptrischen Projektionsobjektiv vorgesehen, entsprechend dem beschriebenen Ausführungsbeispiel.

Anspruch 11 beschreibt eine gesamte Projektionsbelichtungsanlage für die Mikrolithographie mit dem REMA-Objektiv, davor einem Glasstab und nachfolgend einem Projektionsobjektiv mit einer Eintrittspupille und gibt dafür die wesentliche Funktion des REMA-Objektivs, zugleich die Retikel-Maskierung präzise in die Retikelebene zu projizieren, und die Austrittspupille des REMA-Objektivs auf die Eintrittspupille des Projektionsobjektivs sauber abzustimmen.

Das führt insgesamt dazu, daß die in einem zwischen Lichtquelle und Glasstab angeordneten Objektiv erzeugte besondere Beleuchtungscharakteristik - gewöhnliche Beleuchtung mit variabler Apertur, also Kohärenzgrad σ, Ringaperturbeleuchtung, symmetrische schiefe Beleuchtung, Quadrupolbeleuchtung - (wie z.B. in EP-A 0 687 956 (94038 P EP) und dortigen Zitaten beschrieben), für alle Punkte des Retikels einwandfrei in die Eintrittspupille des Projektionsobjektivs übertragen wird.

Näher erläutert wird die Erfindung anhand des in der Zeichnung wiedergegebenen Ausführungsbeispiels.

Es zeigen
- Figur 1: einen Linsenschnitt eines REMA-Objektivs;
- Figur 2: eine schematische Übersicht über eine Mikrolithographie-Projektionsbelichtungsanlage.

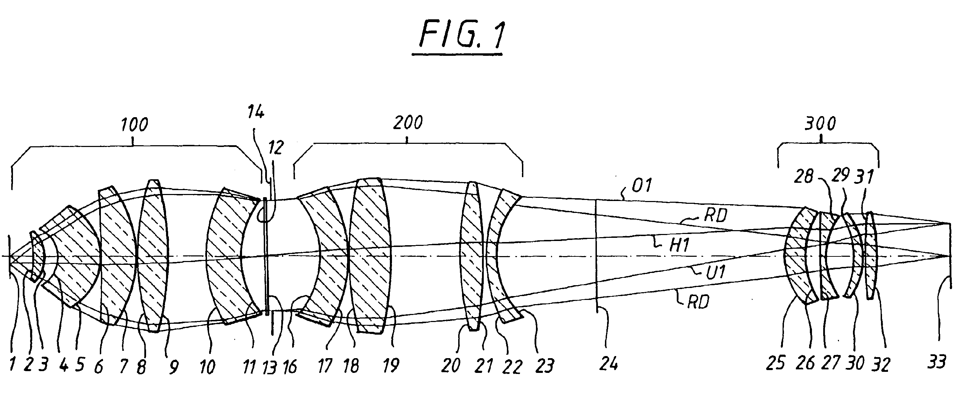

Das im Linsenschnitt Figur 1 gezeigte REMA-Objektiv hat drei Linsengruppen 100, 200, 300. Die Pupillenebene 14 liegt hinter der Planplatte 12/13. Bei der Fläche 23 ist Raum für den Einbau eines Umlenkspiegels, der zur kompakten Unterbringung in der Belichtungsanlage Bedeutung hat. Zwischen der dritten Linsengruppe 300 und der Bildebene 33 bleibt ein freier Arbeitsabstand, so daß für die Befestigung und Handhabung des Retikels genügend Raum bleibt. Eingezeichnet sind der Hauptstrahl H1, die Randstrahlen RD und der obere O1 und untere U1 Komastrahl. Tabelle 1 gibt die Radien und Abstände der Linsen mit den Flächen 2 bis 32, die alle aus Quarzglas gefertigt sind, bezogen auf die Objektebene 1 und die Bildebene 33 an.

Tabelle 2 gibt die Daten des dazu exakt passenden katadioptrischen Reduktionsobjektivs nach PCT/EP95/01719 Figur 3 und Tabelle 2 an.

In Tabelle 1 ist auch für die Randstrahlen RD, den Hauptstrahl H1 und den oberen O1 und unteren U1 Komastrahl der Sinus des Einfallswinkels auf die Flächen - sin (i_{Rand}), sin (i_{Haupt}), sin (i_{Koma oben}), sin (i_{Koma unten}) - angegeben.

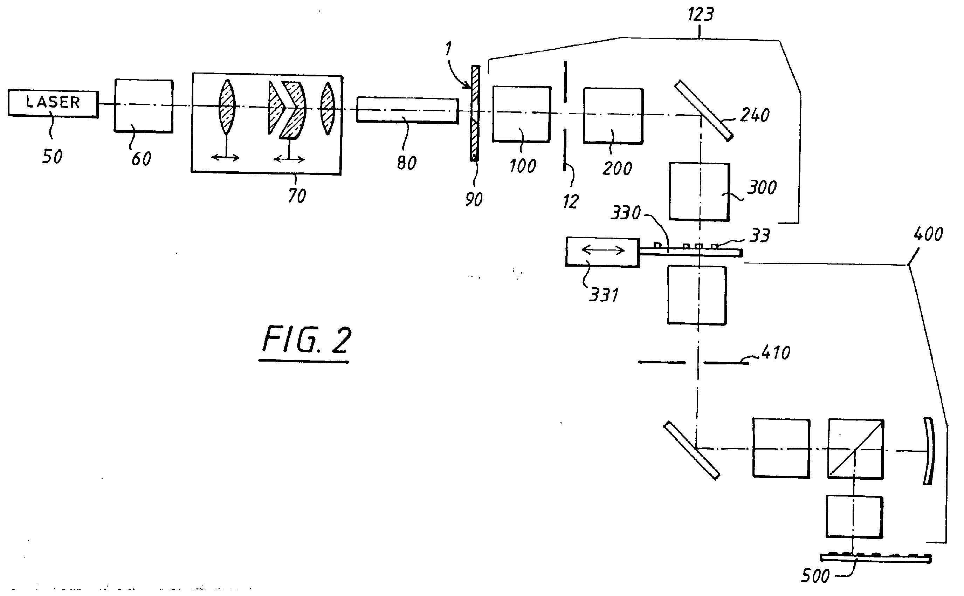

Figur 2 zeigt einen schematischen Überblick über den optischen Teil einer gesamten Projektionsbelichtungsanlage (Wafer-Stepper).

Ein KrF-Excimer-Laser 50 mit 248 nm Wellenlänge dient als Lichtquelle. Eine Einrichtung 60 dient zur Strahlformung und Kohärenzreduktion. Ein Zoom-Axicon-Objektiv 70 ermöglicht die bedarfsgerechte Einstellung verschiedener Beleuchtungsarten. Es ist, wie die gesamte Anordnung (außer den erfindungsgemäßen Merkmalen des REMA-Objektivs 123) beispielsweise aus der EP-A 0 687 956 oder aus DE-U 94 09 744 (beide von der Anmelderin) bekannt. Das Licht wird in den Glasstab 80 eingekoppelt, der zur Mischung und Homogenisierung dient.

Unmittelbar daran schließt das Retikel-Maskierungssystem 90 an, das in der Objektebene 1 des REMA-Objektivs 123 liegt. Dieses besteht aus der ersten Linsengruppe 100, der Pupillenebene (Blendenebene) 14, der zweiten Linsengruppe 200, dem Umlenkspiegel 240, der dritten Linsengruppe 300 und der Bildebene 33. Hier ist das Retikel 330 angeordnet, das von der Wechsel- und Justiereinheit 331 präzise positioniert wird. Es folgt das katadioptrische Projektionsobjektiv 400 nach PCT/EP95/01719 mit der Pupillenebene 410. Die Eintrittspupille liegt im Ausführungsbeispiel der Tabellen 1 und 2 allerdings nahezu im Unendlichen vor dem Projektionsobjektiv. In der Bildebene ist der Wafer 500 angeordnet.

Die Hauptstrahlen verlassen die Objektebene 1 des REMA-Objektivs 123 nahezu senkrecht.
Zwischen den Linsenflächen 3 und 4 befindet sich der zur Objektebene 1 hin gekrümmte zerstreuende Luftraum gemäß Anspruch 6.

Nächst der Pupillenebene 14 ist die dünne Planplatte 12/13 angeordnet, als Statthalter für hier mögliche Blenden, Filter und dergleichen. Die Pupille ist für eine saubere Weiterverarbeitung dieser Blenden etc. ausreichend gut korrigiert. Demgemäß ist der Objektivteil bis zur Pupille 14 als Teilobjektiv korrigiert, dessen Objekt im Unendlichen, dessen Blende am Ort der Objektebene 1 des REMA-Objektivs 123, und dessen Bildebene am Ort der Blendenebene des gesamten REMA-Objektivs 123 liegt, und bei dem die Koma als Querabweichungen kleiner ist als 1 %, vorzugsweise kleiner als 0,2 %, des Bildfelddurchmessers dieser Teilabbildung.

Die Flächen 11 und 16 erfüllen die Bedingung des Anspruches 3, denn sie sind zur Pupillenebene 12 hin gekrümmt und für die Fläche 11 ist |sin (i_{Rand})| = 0,62, für die Fläche 16 ist |sin (i_{Rand})| = 0,66. Die objektivseitige numerische Apertur ist NAO = 0,60 (gleich |sin (i_{Rand})| an der Objektebene 1). Bei Varianten liegt sie vorzugsweise zwischen 0,35 und 0,75.

Damit ist der Quotient |sin(i_{Rand})| : NAO für beide Flächen größer als 1 und erst recht größer als 0,8.

Zwischen einer dieser Flächen mit der Eigenschaft des Anspruchs 3 und der Pupillenebene sollte möglichst nicht mehr als eine Linse liegen.

Zusätzlich ist vorgesehen, daß zwischen Blendenebene 14 und Retikelebene 33 eine Fläche 23 liegt, mit einem größten Betrag des Sinus des Auftreffwinkels eines Komastrahles in Luft gegen die Flächennormale |sin (i_{Koma max}.)| größer als 0,8 mal die eingangsseitige numerische Apertur NAO.

Diese Flächen beeinflussen vorteilhaft die Petzvalsumme und die sphärische Aberration.

In der dritten Linsengruppe 300 sind die Hauptstrahlhöhen größer als die Randstrahlhöhen und die Fläche 28 ist zerstreuend, |sin (i_{Haupt})| ist 0,54, also größer als 0,5, wie im Anspruch 1 bevorzugt wird. Entsprechend nahe liegt die dritte Linsengruppe 300 an der Retikelebene 33.

Diese dritte Linsengruppe 300 hat eine positive Brennweite und dient der Anpassung der Hauptstrahlen des REMA-Objektivs 123 an die Hauptstrahlen des Projektionsobjektivs 400. In jedem beleuchteten Punkt der Retikelebene 33 unterscheidet sich der Schwerstrahl des auftreffenden Lichtkegels nur wenig vom vorgegebenen Hauptstrahl des nachfolgenden Projektionsobjektivs 400. Es ist vorgesehen, daß die Winkelabweichung unter 3 Millirad liegt. Bei dem gezeigten Beispiel nach Tabelle 1 in Verbindung mit dem Projektionsobjektiv 400 nach Tabelle 2 liegt diese Abweichung unter 1 Millirad.

Für diese Hauptstrahlanpassung besonders nützlich ist die vorgesehene stark zerstreuende Fläche 28, für die gilt |sin (i_{Haupt})| = 0,54. Der Wert entspricht also der Forderung des Anspruchs 1. Dieser große i-Winkel ermöglicht es, den Hauptstrahl H1 der Eintrittspupille 420 des Projektionsobjektivs 400 anzupassen.

Die Verzeichnung des REMA-Objektivs 123 ist auf weniger als 0,5 % korrigiert. Anzustreben sind generell weniger als 3 %, bzw. weniger als 0,5 %. Dazu ist vorteilhafterweise eine krumme Sammelfläche in der dritten Linsengruppe 300 vorzusehen, für die gilt |sin (i_{Haupt})| ≥ 0,35. Dies ist hier die Fläche 25 mit |sin (i_{Haupt})| = 0,47.

Das REMA-Objektiv gemäß der Erfindung, insbesondere gemäß dem Ausführungsbeispiel, ist auch hinsichtlich der Bereitstellung freier Räume in den Bereichen der Objekt- und Bildebene und der Pupille für die Praxis gut geeignet.

Die gesamte Baulänge 1-33 beträgt 1200 mm, je nach Ausführung können ca. 500 - 2000 mm vorkommen. Der freie Abstand zwischen Objektebene 1 und erster Objektivfläche 2 beträgt rund 30 mm. Mindestens ca. 5 mm werden generell angestrebt, damit in der Objektebene 1 die variable Retikel-Maskierungsblende 90 gut untergebracht werden kann.

Nach der nächst der Pupillenebene 14 angeordneten Planplatte 12/13 ist ein Freiraum von über 60 mm geschaffen, so daß hier gut eine Wechseleinrichtung für Planplatten 12/13 mit unterschiedlicher Filter- und Blendenwirkung angeordnet werden kann.

Zwischen der zweiten 200 und dritten 300 Linsengruppe liegt ein Freiraum, der deutlich länger als der Querschnitt der Lichtröhre ist, so daß im Bereich der eingezeichneten Ebene 24 - aber auch dagegen verschoben - ein Umlenkspiegel 240 angeordnet werden kann (vgl. Figur 2).

Auch der freie Abstand 32-33 des Objektivs zur Retikelebene ist mit über 90mm (7,5 % der Baulänge) reichlich bemessen. Über 3 % der Baulänge sind hier bei allen Varianten angestrebt, um für die Halterung des Retikels 330 einschließlich Wechsel- und Justiereinrichtung 331 genügend Platz zu lassen.

Der objektseitige Hauptstrahl ist im Beispiel und vorzugsweise senkrecht zu der Objektebene 1.

Die Objektebene 1 kann mit der Austrittsfläche des Glasstabs 80 zusammenfallen. Zur Anbringung einer variablen Objektfeldblende - der Retikelmaskierung 90 - ist jedoch ein geringer Abstand zum Glasstab 80 nötig, der aber kleiner als 0,8 % der Baulänge des REMA-Objektivs 123 bleibt.

Das REMA-Objektiv 123 bildet die Objektebene 1 im Maßstab β = - 4,444 im Beispiel, generell über 2-fach, in der Regel 3- bis 8-fach vergrößernd ab.

Das ist zum einen dadurch bedingt, daß der Bildfelddurchmesser in der Retikelebene 33 so groß sein muß wie der Objektfelddurchmesser des Projektionsobjektivs 400. Bei einem Bildfelddurchmesser auf dem Wafer 500 von 30 mm muß bei einem 4- bzw. 5-fach reduzierendem Projektionsobjektiv 400 also der Bildfelddurchmesser des REMA-Objektivs 120 mm bzw. 150 mm sein.

Der Durchmesser sinnvoller Glasstäbe 80 ist aber deutlich geringer, so daß hier eine hohe Vergrößerung benötigt wird. Bei Wabenkondensoren sind die Durchmesser aber im allgemeinen deutlich größer als bei Glasstäben, so daß eine solche Vergrößerung dann nicht benötigt wird.

Die erste Linsengruppe 100 ist als Teilobjektiv ausgebildet. Seine Objektebene liegt im Unendlichen, die Blende am Ort der Objektebene 1 des gesamten REMA-Objektivs 123. Die Randstrahlen des Teilobjektivs entsprechen dann telezentrischen Hauptstrahlen des REMA-Objektivs 123, während die Hauptstrahlen des Teilobjektivs den Randstrahlen des REMA-Objektivs 123 entsprechen. Die Bildebene des Teilobjektivs liegt dann im Bereich der Blendenebene 14 des REMA-Objektivs 123. Die Abbildungsqualität dieser Teilabbildung ist so, daß der Maximalwert der Koma als Querabweichung kleiner ist als 1 %, vorzugsweise kleiner als 0,2 % des Bildfelddurchmessers dieser Teilabbildung. Im Beispiel ist dieser Wert kleiner als 0,2 %.

Für diese Komakorrektion ist im Teilobjektiv 100 mindestens eine zur Objektebene 1 hin krumme Hohlfläche angeordnet, für die gilt: |sin (i_{Rand})| ≤ 0,8 NAO (objektseitige numerische Apertur des REMA-Objektivs 123) für den Randstrahlwinkel und |sin (i_{Koma max})| ≥ 0,8 ' NAO für den größten auftretenden Komastrahlwinkel im Teilobjektiv 100.

Im Ausführungsbeispiel erfüllt diese Bedingung die Fläche 4 mit |sin (i_{Rand})| = 0,43 und |sin (i_{Koma max})| = 0,65 (NAO ist 0,6).

Das REMA-Objektiv kann achromatisiert werden, beispielsweise durch Ausbildung der krummen Menisken 10, 11 und 16, 17 in Blendennähe als Kittglieder.

Das gezeigte Ausführungsbeispiel ist für DUV-Licht bei 248 nm Wellenlänge angegeben. Sowohl niedrigere - z.B. 193 nm - als auch höhere Wellenlängen - z.B. i-Linie bei 365 nm sind durch geringe Anpassung des Designs möglich.

**Tabelle 1**

| Wellenlänge Lambda = 248,38 nm Abbildungsmaßstab β = -4,44 | | | | numerische Apertur = 0,6 | | | |
|---|---|---|---|---|---|---|---|
| Nr. | Radius | Dicke | Glas | RD | 01 | H1 | U1 |
| 1 | Plan | 30.72 | | .60 | .60 | .00 | -.60 |
| 2 | -86.28 | 13.81 | Quarz | .38 | .47 | .11 | -.29 |
| 3 | -44.80 | 18.11 | | .15 | .07 | .28 | .38 |
| 4 | -39.93 | 55.00 | Quarz | -.43 | -.19 | .28 | .65 |
| 5 | -76.61 | 1.00 | | -.43 | -.29 | .16 | .56 |
| 6 | -1047.19 | 43.85 | Quarz | .37 | .39 | .03 | -.36 |
| 7 | -153.10 | 2.00 | | -.35 | -.25 | .11 | .45 |
| 8 | 326.10 | 38.48 | Quarz | .45 | .46 | .01 | -.44 |
| 9 | -396.62 | 43.07 | | -.29 | -.20 | .10 | .38 |
| 10 | 164.06 | 45.00 | Quarz | .44 | .48 | .04 | -.40 |
| 11 | 117.72 | 28.67 | | .62 | .67 | .05 | -.56 |
| 12 | Plan | 1.50 | Quarz | .01 | .09 | .08 | .06 |
| 13 | Plan | 2.00 | | | | | |
| 14 | Blende | 67,45 | | | | | |
| 16 | -108.16 | 37.23 | Quarz | -.66 | -.62 | .03 | .69 |
| 17 | -165.92 | 1.06 | | -.38 | -.34 | .03 | .41 |
| 18 | 494.18 | 55.65 | Quarz | .32 | .41 | .10 | -.24 |
| 19 | -345.37 | 36.53 | | -.34 | -.33 | .02 | .36 |
| 20 | 369.96 | 30.69 | Quarz | .13 | .22 | .10 | -.04 |
| 21 | -685.05 | 2.57 | | -.37 | -.38 | -.00 | .36 |
| 22 | 183.76 | 12.67 | Quarz | .14 | .23 | .11 | -.05 |
| 23 | 107.14 | 127.91 | | .52 | .70 | .21 | -.34 |
| 24 | Plan | 239.33 | | -.12 | -.04 | .05 | .17 |
| 25 | 87.96 | 27.87 | Quarz | .17 | .69 | .47 | .27 |
| 26 | 111.57 | 16.73 | | .02 | .32 | .29 | .27 |
| 27 | 744.34 | 8.60 | Quarz | -.15 | -.14 | .03 | .19 |
| 28 | 87.96 | 35.54 | | .11 | .69 | .54 | .41 |
| 29 | -105.49 | 11.35 | Quarz | -.22 | -.40 | -.18 | .04 |
| 30 | -89.35 | 1.31 | | -.25 | -.59 | -.33 | -.07 |
| 31 | 403.64 | 14.72 | Quarz | -.06 | .17 | .22 | .28 |
| 32 | -313.72 | 94.55 | | -.18 | -.30 | -.13 | -.05 |
| 33 | Plan | | | -.13 | -.13 | .00 | .14 |

**Tabelle 2**

| Wellenlänge Lambda = 248,38 nm | | numerische Apertur NA = 0,70 | |
|---|---|---|---|
| Abbildungsmaßstab β = - 0,25 | | Glas: Quarz n = 1,50834 | |
| Nr. | Radius | Dicke | Glas |
| | | 46,25 | |
| 1 | -208,30 | | |
| | | 11,38 | Quarz |
| 2 | -498,48 | | |
| | | 1,00 | |
| 3 | 368,29 | | |
| | | 16,30 | Quarz |
| 4 | -173,64 | | |
| | | 55,82 | |
| 5 | Plan | | |
| | | 66,00 | |
| 6 | -127,78 | | |
| | | 9,70 | Quarz |
| 7 | 251,15 | | |
| | | 79,28 | |
| 8 | 1891,95 | | |
| | | 38,73 | Quarz |
| 9 | -160,51 | | |
| | | 1,03 | |
| 10 | -2818,18 | | |
| | | 15,49 | Quarz |
| 11 | 263,13 | | |
| | | 13,96 | |
| 12 | 997,93 | | |
| | | 29,30 | Quarz |
| 13 | -273,97 | | |
| | | 1,00 | |
| 14 | Plan | | |
| | | 95,50 | Quarz |
| 15 | Plan | | |
| | | 95,50 | Quarz |
| 16 | Plan | | |
| | | 21,10 | |
| 17 | -245,27 | | |
| | | 15,63 | Quarz |
| 18 | 3216,71 | | |
| | | 15,16 | |
| 19 | -437,42 | Spiegel | |
| | | 15,16 | |
| 20 | -3216,71 | | |
| | | 15,63 | Quarz |
| 21 | 245,27 | | |
| | | 21,10 | |
| 22 | Plan | | |
| | | 191,0 | Quarz |
| 23 | Plan | | |
| | | 1,00 | |
| 24 | 278,04 | | |
| | | 24,57 | Quarz |
| 25 | 4615,58 | | |
| | | 63,39 | |
| 26 | 262,26 | | |
| | | 40,81 | Quarz |
| 27 | -620,91 | | |
| | | 1,08 | |
| 28 | 208,55 | | |
| | | 24,75 | Quarz |
| 29 | -2336,21 | | |
| | | 6,67 | |
| 30 | -441,28 | | |
| | | 15,29 | Quarz |
| 31 | 1144,28 | | |
| | | 1,06 | |
| 32 | 71,95 | | |
| | | 36,07 | Quarz |
| 33 | 50,36 | | |
| | | 13,64 | |
| 34 | 60, 47 | | |
| | | 53,85 | Quarz |
| 35 | 3672,41 | | |
| | | 6,34 | |
| 36 | | | Bild (Wafer) |

## Patentansprüche

1. REMA-Objektiv (123), das eine in endlichem Abstand liegende Objektebene (1) auf die Retikelebene (33) abbildet, mit einer in der retikelnahen Objektivhälfte liegenden Linsengruppe (300), in der die Hauptstrahlhöhen betragsmäßig größer sind als die Randstrahlhöhen, in der eine zerstreuende Fläche (28) mit einem größten Betrag des Sinus des Auftreffwinkels eines Hauptstrahls in Luft gegen die Flächennormale (|sin (i_{Haupt})|) größer als 0,35, vorzugsweise größer als 0,5 angeordnet ist.

2. REMA-Objektiv nach Anspruch 1, **dadurch gekennzeichnet, daß** in Lichtrichtung hinter dem REMA-Objektiv (123) der reziproke Wert der auf das Retikel (330) bezogenen Hauptstrahlschnittweite für achsferne Hauptstrahlen im mathematischen Sinn kleiner als für achsnahe Hauptstrahlen ist.

3. REMA-Objektiv, **dadurch gekennzeichnet, daß** vor oder vor und hinter dem Schnittpunkt der Hauptstrahlen (H1) mit der optischen Achse mindestens eine optische Fläche (11) eine zu diesem Schnittpunkt hin gekrümmte Fläche ist, mit einem größten Betrag des Sinus des Auftreffwinkels gegen die Flächennormale eines Randstrahls in Luft (|sin (i_{Rand})|) größer als das 0,8-fache der objektseitigen numerischen Apertur (NAO).

4. REMA-Objektiv nach Anspruch 3, **dadurch gekennzeichnet, daß** zwischen Blendenebene (14) und Retikelebene (33) mindestens eine Fläche (23) angeordnet ist mit einem größten Betrag des Sinus des Auftreffwinkels eines Komastrahls in Luft gegen die Flächennormale (|sin (i_{Koma max.})|) größer als 0,8 mal die objektseitige numerische Apertur (NAO) des REMA-Objektivs (123).

5. REMA-Objektiv nach Anspruch 4, **dadurch gekennzeichnet, daß** die Abbildung einer Hell-Dunkel-Kante von der Objektebene (1) auf die Retikelebene (33) einen Kantenverlauf ergibt, dessen Helligkeitswerte 5 % und 95 % um weniger als 2 %, vorzugsweise weniger als 0,5 % des Bildfelddurchmessers auseinanderliegen.

6. REMA-Objektiv, **dadurch gekennzeichnet, daß** zwischen Objektebene (1) und Blendenebene (14), welche den Schnittpunkt der Hauptstrahlen (H1) mit der optischen Achse enthält, ein zur Objektebene (1) hin gekrümmter zerstreuender Luftspalt (3, 4) angeordnet ist.

7. REMA-Objektiv nach mindestens einem der Ansprüche 1-6, **dadurch gekennzeichnet, daß** es ein Teilobjektiv (100) enthält, welches eine korrigierte Pupillenebene (14) erzeugt.

8. REMA-Objektiv nach Anspruch 6, **dadurch gekennzeichnet, daß** es mindestens eine zur Objektebene (1) hin gekrümmte Hohlfläche (4) aufweist, an der der Betrag des Sinus des Auftreffwinkels eines Randstrahls in Luft gegen die Flächennormale (|sin (i_{Rand})|) kleiner als 0,8 mal die objektseitige numerische Apertur (NAO) des REMA-Objektivs ist, und der größte Betrag des Sinus des Auftreffwinkels eines Komastrahls (|sin (i_{Koma-max.})|) größer als 0,8 mal die objektseitige numerische Apertur (NAO) des REMA-Objektivs ist.

9. REMA-Objektiv nach mindestens einem der Ansprüche 1-8, **gekennzeichnet durch** die Verwendung in einer Mikrolithographie-Projektionsbelichtungsanlage, in der die Retikel-Maskierung (90) am Ausgang eines Glasstabs (80) angeordnet ist.

10. REMA-Objektiv nach mindestens einem der Ansprüche 1-9, **gekennzeichnet durch** die Verwendung in einer Mikrolithographie-Projektionsbelichtungsanlage, in der das Projektionsobjektiv (400) ein verkleinerndes katadioptrisches Objektiv ist.

11. Projektionsbelichtungsanlage für die Mikrolithographie mit einer Beleuchtungseinrichtung enthaltend einen Glasstab (80) und ein REMA-Objektiv (123) und mit einem Projektionsobjektiv (400) mit einer Eintritts-Pupillenebene (410), **dadurch gekennzeichnet, daß** das REMA-Objektiv (123) nach mindestens einem der Ansprüche 1-10 enthaltend Anspruch 7 ausgeführt ist, und daß die Pupillenebene (14) des REMA-Objektivs (123) in die Pupillenebene (410) des Projektionsobjektivs (400) abgebildet wird.

## Claims

1. REMA objective (123), which images an object plane (1) situated at a finite distance onto the reticle plane (33), comprising a lens group (300) situated in the objective half near the reticle, in which lens group the principal ray heights are greater in magnitude than the marginal ray heights, and in which lens groups is arranged a diverging surface (28) with a maximum magnitude of the sine of the angle of impingement of a principal ray in air relative to the surface normal (|sin (i_{principal})|) greater than 0.35, preferably greater than 0.5.

2. REMA objective according to Claim 1, **characterized in that**, in the light direction downstream of the REMA objective (123), the reciprocal value of the principal ray vertex focal length relative to the reticle (330) is smaller in the mathematical sense for principal rays remote from the axis than for principal rays near the axis.

3. REMA objective, **characterized in that**, upstream or upstream and downstream of the point of intersection of the principal rays (H1) with the optical axis, at least one optical surface (11) is a surface curved towards this point of intersection, with a maximum magnitude of the sine of the angle of impingement relative to the surface normal of a marginal ray in air (|sin (i_{marginal})|) greater than 0.8 times the object-side numerical aperture (NAO).

4. REMA objective according to Claim 3, **characterized in that**, between diaphragm plane (14) and reticle plane (33), at least one surface (23) is arranged with a maximum magnitude of the sine of the angle of impingement of a coma ray in air relative to the surface normal (|sin (i_{coma max}.)|) greater than 0.8 times the object-side numerical aperture (NAO) of the REMA objective (123).

5. REMA objective according to Claim 4, **characterized in that** the imaging of a bright-dark edge from the object plane (1) onto the reticle plane (33) produces an edge profile whose brightness values 5% and 95% are separated by less than 2%, preferably less than 0.5%, of the image field diameter.

6. REMA objective, **characterized in that** a diverging air gap (3, 4) curved towards the object plane (1) is arranged between object plane (1) and diaphragm plane (14) containing the point of intersection of the principal rays (H1) with the optical axis.

7. REMA objective according to at least one of Claim 1-6, **characterized in that** it contains a partial objective (100) which produces a corrected pupil plane (14).

8. REMA objective according to Claim 6, **characterized in that** it has at least one concave surface (4) which is curved towards the object plane (1) and at which the magnitude of the sine of the angle of impingement of a marginal ray in air relative to the surface normal (|sin (i_{marginal})| ) is less than 0. 8 times the object-side numerical aperture (NAO) of the REMA objective, and the maximum magnitude of the sine of the angle of impingement of a coma ray (|sin (i_{coma max.})|) is greater than 0.8 times the object-side numerical aperture (NAO) of the REMA objective.

9. REMA objective according to at least one of Claims 1-8, **characterized by** the use in a microlithography projection exposure apparatus in which the reticle masking (90) is arranged at the output of a glass rod (80).

10. REMA objective according to at least one of Claims 1-9, **characterized by** the use in a microlithography projection exposure apparatus in which the projection objective (400) is a reducing catadioptric objective.

11. Projection exposure apparatus for microlithography comprising an illumination device containing a glass rod (80) and a REMA objective (123) and comprising a projection objective (400) with an entrance pupil plane (410), **characterized in that** the REMA objective (123) is embodied according to at least one of claims 1-10 including Claim 7, and **in that** the pupil plane (14) of the REMA objective (123) is imaged into the pupil plane (410) of the projection objective (400).

## Revendications

1. Objectif REMA (123) qui reproduit sur le plan de réticule (33) un plan d'objet (1) se trouvant à une distance finie, comprenant un groupe de lentilles (300) qui se trouve dans la moitié d'objectif à proximité du réticule, dans lequel les hauteurs du rayon principal sont supérieures en valeur absolue aux hauteurs des rayon de bordure, dans lequel une surface de dispersion (28) est disposée selon un angle d'incidence d'un rayon principal dans l'air sur la normale de la surface dont le sinus (|sin (i_{Haupt})|) est au plus supérieur à 0,35, de préférence supérieur à 0,5.

2. Objectif REMA selon la revendication 1, **caractérisé en ce qu'**à l'arrière de l'objectif REMA (123), dans le sens de la lumière, la valeur réciproque de la distance focale du rayon principal rapportée au réticule (330) pour les rayons principaux éloignés de l'axe est inférieure dans le sens mathématique à celle pour les rayons principaux proches de l'axe.

3. Objectif REMA, **caractérisé en ce que** devant ou devant et derrière le point d'intersection des rayons principaux (H1) avec l'axe optique, au moins une surface optique (11) est une surface courbée en direction de ce point d'intersection, l'angle d'incidence d'un rayon de bordure dans l'air sur la normale de la surface (|sin (i_{Rand})|) présentant un sinus au plus supérieur à 0,8 fois l'ouverture numérique (NAO) du côté de l'objet.

4. Objectif REMA selon la revendication 3, **caractérisé en ce qu'**entre le plan du diaphragme (14) et le plan du réticule (33) est disposée au moins une surface (23) dont l'angle d'incidence d'un rayon de coma dans l'air sur la normale de la surface (|sin (i_{Koma max.})|) présente un sinus au plus supérieur à 0,8 fois l'ouverture numérique (NAO) du côté de l'objet de l'objectif REMA (123).

5. Objectif REMA selon la revendication 4, **caractérisé en ce que** la représentation d'un bord clair/foncé du plan de l'objet (1) sur le plan du réticule (33) produit un tracé de bord dont les valeurs de la luminosité à 5 % et à 95 % sont espacées l'une de l'autre de moins de 2 %, de préférence de moins de 0,5 % du diamètre du champ d'image.

6. Objectif REMA, **caractérisé en ce qu'**entre le plan de l'objet (1) et le plan du diaphragme (14), lequel contient le point d'intersection des rayons principaux (H1) avec l'axe optique, se trouve un interstice de dispersion (3, 4) courbé en direction du plan de l'objet (1).

7. Objectif REMA selon au moins l'une des revendications 1 à 6, **caractérisé en ce qu'**il contient un objectif partiel (100) qui produit un plan de pupille (14) corrigé.

8. Objectif REMA selon la revendication 6, **caractérisé en ce qu'**il présente au moins une surface creuse (4) courbée en direction du plan de l'objet (1) sur laquelle le sinus de l'angle d'incidence d'un rayon de bordure dans l'air sur la normale de la surface (|sin (i_{Rand})|) est inférieur à 0,8 fois l'ouverture numérique (NAO) du côté de l'objet de l'objectif REMA et la valeur la plus élevée du sinus de l'angle d'incidence d'un rayon de coma (|sin (i_{Koma max.)}|) est supérieure à 0,8 fois l'ouverture numérique (NAO) du côté de l'objet de l'objectif REMA.

9. Objectif REMA selon au moins l'une des revendications 1 à 8, **caractérisé par** l'utilisation dans un équipement d'éclairage par projection microlithographique dans lequel le masque de réticule (90) est disposé à la sortie d'une tige en verre (80).

10. Objectif REMA selon au moins l'une des revendications 1 à 9, **caractérisé par** l'utilisation dans un équipement d'éclairage par projection microlithographique dans lequel l'objectif de projection (400) est un objectif catadioptrique rétrécissant.

11. Équipement d'éclairage par projection pour la microlithographie muni d'un dispositif d'éclairage et comprenant une tige en verre (80) et un objectif REMA (123) ainsi que d'un objectif de projection( 400) doté d'un plan de pupille d'entrée (410), **caractérisé en ce que** l'objectif REMA (123) est réalisé selon au moins l'une des revendications 1 à 10 en incluant la revendication 7 et que le plan de pupille (14) de l'objectif REMA (123) est formé dans le plan de pupille (410) de l'objectif de projection (400).
